Europäisches Patentamt

European Patent Office

Office européen des brevets

(11) Veröffentlichungsnummer: **0 262 412**
**A1**

(12) **EUROPÄISCHE PATENTANMELDUNG**

(21) Anmeldenummer: **87112558.9**

(22) Anmeldetag: **28.08.87**

(51) Int. Cl.⁴: **H03K 5/15**

(30) Priorität: **01.09.86 DE 3629690**

(43) Veröffentlichungstag der Anmeldung:
**06.04.88 Patentblatt 88/14**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Stronski, Sabine**
**Tannenweg 39**
**D-8055 Goldach(DE)**

(54) **Lastangepasster Taktgenerator in CMOS-Schaltungen.**

(57) Die Funktionsfähigkeit einer integrierten Schaltung mit zwei aus einem externen Takt erzeugten internen Takten beruht darauf, daß sich die internen Takte nicht überlappen. Um Phasenverschiebungen der internen Takte aufgrund unterschiedlicher kapazitiver Belastungen bei verschiedenen Betriebszuständen zu vermeiden, wird vorgeschlagen die Ausgangstreiber (T11, T12, I1; T21, T22, I2) des Taktgenerators asymmetrisch so zu dimensionieren, daß diese an die maximal zu treibende kapazitive Last angepaßt sind. Ein weiterer Vorschlag besteht darin, mindestens einen Taktausgang gegen den anderen elektrisch zu verriegeln und ein dritter Vorschlag enthält eine Kombination der beiden anderen.

EP 0 262 412 A1

## Lastangepaßter Taktgenerator in CMOS-Schaltungen

Die Erfindung betrifft einen Taktgenerator nach dem Oberbegriff der Patentansprüche 1, 4 und 9.

Die Funktionsfähigkeit digitaler Schaltungen beruht auf einem Taktsystem, das mit Hilfe von Taktgeneratoren erzeugt wird. Speziell für integrierte Schaltkreise steht häufig ein externer Takt zur Verfügung, der von einem internen, in den Baustein integrierten Taktgenerator zur Erzeugung eines internen Takts ausgewertet wird. Für die verschiedenen Betriebszustände der integrierten Schaltung sind oft zwei nicht überlappende interne Takte erforderlich, die zu keinem Zeitpunkt gleichzeitig auf einem hohe Pegel liegen dürfen. Üblicherweise werden diese nicht überlappenden internen Takte durch Frequenzteilung aus dem externen Takt erzeugt.

Für einen Taktgenerator zur Erzeugung der zwei nicht überlappenden internen Takte ist die Verwendung eines Flip-Flops mit symmetrisch dimensionierten Ausgangstreibern üblich, wobei das Flip-Flop vom externen Takt über den Frequenzteiler angesteuert wird. Abhängig von der Komplexität der integrierten Schaltung und den verschiedenen Betriebszuständen müssen vom internen Taktgenerator unterschiedlich viele Leitungen aufgeladen werden. Da diesen Leitungen physikalisch eine Kapazität zugeordnet werden kann, schwankt folglich die kapazitive Belastung der von dem Taktgenerator erzeugten Takte. So kann beispielsweise die Belastung eines Takts um den Faktor 15 schwanken, aber auch beide Takte gegeneinander können hinsichtlich ihrer maximalen kapazitiven Belastung um ein Mehrfaches voneinander verschieden sein.

Eine stark schwankende kapazitive Belastung eines derartigen Taktgenerators kann jedoch zu Phasenverschiebungen der Takte führen, so daß nicht mehr sicher gewährleistet ist, daß die Takte sich nicht überlappen.

Der Erfindung liegt die Aufgabe zugrunde, einen Taktgenerator anzugeben, der auch bei unterschiedlicher kapazitiver Belastung zwei nicht überlappende Takte erzeugt.

Diese Aufgabe wird bei einem Taktgenerator der eingangs genannten Art erfindungsgemäß durch die Merkmale der kennzeichnenden Teile der Patentansprüche 1, 4 und 9 gelöst.

Der erfindungsgemäße Taktgenerator besitzt den Vorteil, daß er mit seinen asymmetrischen Ausgangs-und Treiberstufen optimal an die zu versorgende Schaltung angepaßt werden kann und somit wenig Platz beansprucht. Er besitzt den anderen Vorteil, daß auch bei symmetrischen Ausgangs-und Treiberstufen mit Hilfe der Verriegelung zwei nicht überlappende Takte mit einfachen Mitteln sichergestellt sind und den zusätzlichen Vorteil der Redundanz, wenn die Einzellösungen gemäß Anspruch 9 kombiniert werden.

Weitere Ausgestaltungen der Erfindung sind in Unteransprüchen gekennzeichnet.

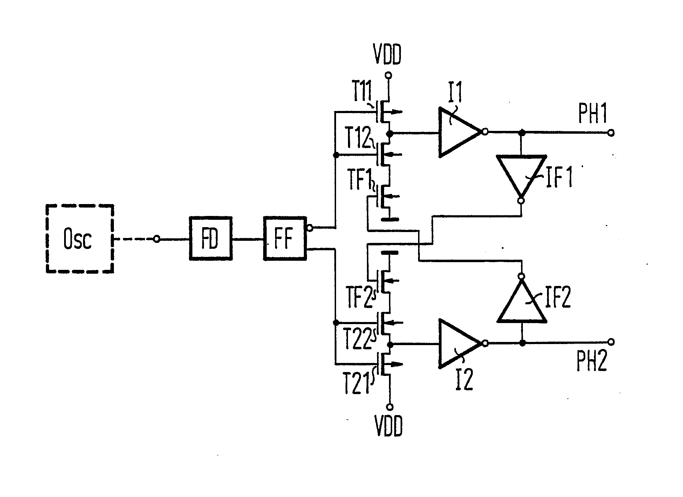

Die Erfindung wird im folgenden anhand der Figur der Zeichnung näher erläutert.

In einen erfindungsgemäßen Taktgenerator wird, wie üblich, von einem externen Oszillator Osc ein externer Takt eingespeist, der mit Hilfe eines Frequenzteilers FD intern auf die halbe Frequenz geteilt wird. Der Ausgang des Frequenzteilers FD steuert dann ein Flip-Flop FF, das komplimentäre Ausgänge besitzt, so daß zwei nicht überlappende Taktsignale zur Verfügung stehen. Diese Ausgangssignale des Flip-Flops FF genügen jedoch nicht zur Steuerung der integrierten Schal tung, da diese mit ihren Leitungen eine kapazitive Belastung darstellt, für die der Ausgangsstrom des Flip-Flops FF unzureichend ist. Den Ausgängen des Flip-Flops FF sind deshalb jeweils eine gleiche Anzahl, in der Regel mehrere, im Ausführungsbeispiel zwei in Serie geschaltete Inverter-Treiberstufen T11, T12, I1, T21, T22, I2 nachgeschaltet, die für einen entsprechenden Ausgangsstrom an den Taktausgängen PH1 und PH2 des Taktgenerators sorgen. Die für jeden Takt erforderliche Anzahl von Inverter-Treiberstufen richtet sich nach der Höhe des geforderten Stroms, wobei ein mehrstufiger Ausgangstreiber gegenüber einem einstufigen Ausgangstreiber für den gleichen Strom gewährleistet, daß die Flankensteilheit der Taktsignale weitgehend erhalten bleibt. Die notwendigen Ausgangsströme ergeben sich aus der zur Verfügung stehenden Taktzeit und der jeweils aufzuladenden Kapazität.

Erfindungsgemäß werden nun die Ausgangs-Treiberstufen T11, T12, I1, T21, T22 und I2 asymmetrisch dimensioniert, so daß die Treiberstufen an die unterschiedlichen Belastungen angepaßt sind. Bei jeweils mehreren hintereinander geschalteten Treiberstufen können die Ausgangs-Treiberstufen dabei so dimensioniert sein, daß sich insgesamt für die zu treibende Last ein dieser kapazitiven Last angepaßter asymmetrischer Ausgangsstrom ergibt. Vorteilhaft ist es, die Dimensionierung der Treiberstufen so vorzunehmen, daß diese jeweils an die maximal zu treibende kapazitive Last angepaßt sind.

Die Dimensionierung der Treiberstufen erfolgt speziell in der CMOS-Technik des Ausführungsbeispiels über die Dimensionierung der MOS-Transistoren vom p-bzw. n-Kanal-Typ. Die Dimensionierung der Transistoren bezieht sich dabei nicht nur auf die Dimensionierung der einzelnen Treiberstufen für jeden Takt, sondern auch auf die Dimensionierung der einzelnen Transistoren einer Treiberstufe. Üblicherweise erfolgt die Dimensionierung über das Verhältnis von Kanalweite zu Kanallänge der einzelnen Transistoren. Damit kann auch berücksichtigt werden, daß MOS-Transistoren vom p-Kanal-Typ langsamer durchschalten als MOS-Transistoren vom n-Kanal-Typ, so daß auch bei hoher Flankensteilheit eine optimale Lastanpassung erfolgt. Über das Verhältnis der Kanalweiten des p-Kanal-und des n-Kanal-Transistors kann gleichzeitig der Eingangspegel, d.h. der Pegel, bei dem die Treiberstufen von einem logischen Zustand in einen anderen logischen Zustand umschalten, optimal auf die Lastverhältnisse an den Taktausgängen angepaßt werden.

Eine weitere Lösung der gestellten Aufgabe besteht darin, einen oder beide Taktausgänge elektrisch gegen den jeweils anderen zu verriegeln. Vorzugsweise erfolgt diese Verriegelung vom Ausgang der letzten, den Taktausgang bildenden Treiberstufe gegen die erste, dem anderen Taktausgang zugeordneten Treiberstufe, die der bistabilen Kippstufe bzw. dem Flip-Flop FF nachgeschaltet ist. Gemäß der Fig. ist im Ausführungsbeispiel eine gegenseitige Verriegelung der Taktausgänge untereinander vorgesehen.

Dazu wird im Ausführungsbeispiel in Serie zu den Transistoren T11, T12 bzw. T21 und T22 jeweils ein Riegeltransistor TF1 bzw. TF2 geschaltet. Vorzugsweise sind die Tranistoren TF1 und TF2 vom n-Kanal-Typ und liegen somit mit ihrem Ausgangskreis zwischen einem Ausgang des n-Kanal-Transistors T12 bzw. T22 der jeweiligen Inverterstufe und dem Bezugspotential. Transistoren vom n-Kanal-Typ sind schneller als Transistoren vom p-Kanal-Typ und können somit den jeweiligen Inverter schnellstmöglich zu-oder abschalten.

Die Gates der Transistoren T11 und T12 sind vom invertierenden Ausgang des Flip-Flops FF gesteuert, während die Gates der Transistoren T21 und T22 vom nicht invertierenden Ausgang dieses Flip-Flops gesteuert sind. Den jeweiligen Ausgängen der Inverterstufen an den Verbindungspunkten der Aus gangskreise der Tansistoren T11 und T12 bzw. der Transistoren T21 und T22 sind in einer zweiten Inverterstufe die Inverter I1 bzw. I2 nachgeschaltet, deren Ausgänge die Taktausgänge PH1 bzw. PH2 bilden. Der Steueranschluß des Transistors TF1 ist nun vom Taktausgang PH2 gesteuert, während der Steuereingang des Transistors TF2 vom Taktausgang PH1 gesteuert ist. Im Ausführungsbeispiel der Fig. muß zwischen dem jeweiligen Taktausgang und dem Steuereingang des jeweiligen Verriegelungstransistors jeweils ein Inverter IF1 bzw. IF2 angeordnet sein, um das Funktionieren der Schaltung zu gewährleisten.

Die Schaltstelle der jeweils zu verriegelnden Inverter-Treiberstufe, im Ausführungsbeispiel T11 und T12 bzw. T21 T22, liegt vorteilhafterweise gegenüber Inverter-Treiberstufen ohne Verriegelung vergleichsweise hoch. Diese Maßnahme wird durch eine dem Fachmann geläufige Dimensionierung des Verhältnisses von Kanalweite zu Kanallänge der p-und n-Kanal-Transistortypen erreicht. Durch diese Maßnahme und durch die Verriegelung können sich zwar die Takte einerseits nicht überschneiden, andererseits geht nur sehr wenig Zeit verloren, in der nicht jeweils einer der Takte auf hohen Potential liegt.

Gemäß der Erfindung ist es auch möglich, nicht wie im Ausführungsbeispiel beide Taktausgänge gegeneinander, sondern auch nur einen Taktausgang gegen den anderen zu verriegeln. Vorteilhafterweise wird dann der kapazitiv höchstbelastete Taktausgang gegen den anderen Taktausgang verriegelt, so daß dieser andere Taktausgang erst dann ein hohes Potential annehmen kann, wenn der andere höchstbelastete Taktausgang dieses Potential bereits wieder verlassen hat. In jedem Fall kann durch die Festlegung der Schaltschwellen der Verriegelungstransistoren TF1 und TF2 oder der vorgeschalteten Inverter IF1 oder IF2 die erfindungsgemäße Schaltung im Sinne der Aufgabe optimiert werden.

Eine dritte Möglichkeit zur Lösung der Aufgabe besteht darin, die beiden vorgenannten Lösungsmöglichkeiten zu kombinieren, d.h., sowohl eine asymmetrische Dimensionierung der Inverter-Treiberstufen vorzusehen, als auch einen oder beide Taktausgänge gegen den jeweils anderen Taktausgang zu verriegeln.

**Ansprüche**

1. Taktgenerator für CMOS-Schaltungen zur Erzeugung zweier nicht überlappender interner Takte an zwei Taktausgängen mit einem von einem Oszillator gespeisten Frequenzteiler und einer nachgeschalteten, bistabilen Kippstufe mit komplementären Ausgängen, die jeweils eine gleiche Anzahl, gegebenenfalls in Serie geschalteter Inverter-Treiberstufen steuern,
**dadurch gekennzeichnet,** daß die Treiberstufen asymmetrisch dimensioniert sind.

2. Taktgenerator nach Anspruch 1, **dadurch gekennzeichnet,** daß die Treiberstufen in ihrer Dimensionierung an die maximal zu treibende kapazitive Last angepaßt sind.

3. Taktgenerator nach Anspruch 1 oder 2, **dadurch gekennzeichnet,** daß die Transistoren der Treiberstufen ein Verhältnis von Kanalweite zu Kanallänge aufweisen, das für die Transistoren, insbesondere auch für Transistoren vom p-und n-Kanal-Typ unterschiedlich ist.

4. Taktgenerator für CMOS-Schaltungen zur Erzeugung zweier nicht überlappender interner Takte an zwei Taktausgängen mit einem von einem Oszillator gespeisten Frequenzteiler und einer nachgeschalteten, bistabilen Kippstufe mit komplementären Ausgängen, die jeweils eine gleiche Anzahl, gegebenenfalls in Serie geschalteter Inverter-Treiberstufen steuern, **dadurch gekennzeichnet,** daß mindestens ein Taktausgang (PH1, PH2) gegen den anderen (PH2, PH1) elektrisch verriegelt ist.

5. Taktgenerator nach Anspruch 4, **dadurch gekennzeichnet,** daß eine Verriegelung vom Aus gang der letzten, den Taktausgang (PH1, PH2) bildenden Treiberstufe (I1, I2) gegen die erste, der bistabilen Kippstufe (FF) nachgeschalteten und dem anderen Taktausgang (PH2, PH1) zugeordneten Treiberstufe (T21, T22, T11, T12) geschieht.

6. Taktgenerator nach Anspruch 4 oder 5, **dadurch gekennzeichnet,** daß eine Verriegelung mit Hilfe eines mit seinem Ausgangskreis in Reihe zu den Ausgangskreisen der zu verriegelnden Inverter-Treiberstufe (T11, T12, T21, T22) geschalteten Riegeltransistors (IF1, IF2) erfolgt, der vom jeweils anderen Taktausgang (PH2, PH1), gegebenenfalls über einen Inverter (IF2, IF1), gesteuert wird.

7. Taktgenerator nach Anspruch 4 bis 6, **dadurch gekennzeichnet,** daß der Riegeltransistor (IF1, IF2) vom n-Kanal-Typ und mit seinem Ausgangskreis gegen ein Bezugspotential geschaltet ist.

8. Taktgenerator nach Anspruch 4 bis 7, **dadurch gekennzeichnet,** daß die Schaltschwelle der jeweils zu verriegelnden Inverter-Treiberstufe (T11, T12, T21, T22) vergleichsweise hoch liegt.

9. Taktgenerator für CMOS-Schaltungen zur Erzeugung zweier nicht überlappender interner Takte an zwei Taktausgängen mit einem von einem Oszillator gespeisten Frequenzteiler und einer nachgeschalteten, bistabilen Kippstufe mit komplementären Ausgängen, die jeweils eine gleiche Anzahl, gegebenenfalls in Serie geschalteter Inverter-Treiberstufen steuern, **gekennzeichnet** durch eine Kombination der Merkmale der Patentansprüche 1 bis 8.

10. Taktgenerator nach Anspruch 1 bis 9, **dadurch gekennzeichnet,** daß bei einer Einfachverriegelung der kapazitiv höchst belastete Taktausgang den anderen Taktausgang verriegelt.

0 262 412

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-3 961 269 (ALVAREZ JR.) <br> * Figuren 1-3; Spalte 3, Zeile 11 - Spalte 8, Zeile 40 * | 1,3-5 | H 03 K 5/15 |
| A | | 2,9 | |
| Y | DE-A-2 737 544 (SIEMENS) <br> * Figur 1; Seite 4, Zeilen 7-30 * <br> --- | 1,3-5 | |
| A | US-A-4 039 862 (DINGWALL et al.) <br> * Figur 2; Spalte 3, Zeile 1 - Spalte 4, Zeile 37 * <br> --- | 1,3-6 | |
| A | IBM TECHNICAL DISCLOSURE BULLETIN, Band 22, Nr. 3, August 1979, Seiten 1093,1094, New York, US; B. CASSIDY et al.: "Dynamic MOSFET logic clock driver" <br> * Figuren 1,2; Seiten 1093,1094 * <br> --- | 1,3-9 | |
| A | US-A-3 927 334 (CALLAHAN) <br> * Figur 2; Spalte 4, Zeile 30 - Spalte 5, Zeile 7 * <br> --- | 1,3-9 | **RECHERCHIERTE SACHGEBIETE (Int. Cl.4)** |
| A | US-A-3 937 982 (NAKAJIMA) <br> * Figur 4; Spalte 4, Zeilen 21-46 * <br> --- | 6-8 | H 03 K |
| A | US-A-4 456 837 (SCHADE) <br> --- | 1 | |
| A | US-A-4 540 904 (ENNIS et al.) <br> --- | 1 | |
| A | US-A-3 668 436 (BACON) <br> ----- | 1 | |

Der vorliegende Recherchenbericht wurde für alle Patentansprüche erstellt

| Recherchenort | Abschlußdatum der Recherche | Prüfer |
|---|---|---|
| DEN HAAG | 08-12-1987 | FEUER F.S. |